# EUROPÄISCHE PATENTSCHRIFT

(11) **EP 3 744 428 B1**
(45) Veröffentlichungstag und Bekanntmachung des Hinweises auf die Patenterteilung: **06.11.2024**
(21) Anmeldenummer: 19177697.0
(22) Anmeldetag: 31.05.2019
(51) Int. Cl.: B01L 1/02, G01N 17/00, F21V 8/00, G02B 6/42, F21V 33/00, F21S 8/02, F21W 131/411

(54) **PRÜFKAMMER**
TEST CHAMBER
CHAMBRE D'ESSAI

(43) Veröffentlichungstag der Anmeldung: 02.12.2020
(73) Patentinhaber: Weiss Technik GmbH, 35447 Reiskirchen (DE); Climats S.A.S., 33650 Martillac (FR)
(72) Erfinder: EMON, Matthias, 33400 Talence (FR); HAACK, Christian, 35037 Marburg (DE); SCHLOSSER, Volker, 35305 Grünberg (DE); REUSCHEL, Dennis, 35396 Gießen (DE); DIETZ, Ricardo, 35390 Gießen (DE)
(74) Vertreter: advotec.

(56) Entgegenhaltungen:
- EP-A1- 0 331 064
- EP-A1- 0 446 692
- WO-A1-2017/157864
- WO-A1-98/51979
- US-A- 3 813 514
- SAXE STEVEN G: "Solar Energy Materials 19 (1989) 95-109 95 North-Holland, Amsterdam PRISMATIC FILM LIGHT GUIDES: PERFORMANCE AND RECENT DEVELOPMENTS", SOLAR ENERGY MATERIALS, vol. 19, 1 January 1989 (1989-01-01), pages 95 - 109, XP093102992, Retrieved from the Internet <URL:https://pdf.sciencedirectassets.com/272839/1-s2.0-S0165163300X00251/1-s2.0-0165163389900269/main.pdf?X-Amz-Security-Token=IQoJb3JpZ2luX2VjEF4aCXVzLWVhc3QtMSJHMEUCIQCtPH0j5go1kluS6yWZ/8jHFbJ2LScha56NiVDefdmA/gIgcXLdbnHRZlEIx/b+qHkBVLzRiVT6rxC3VoupJw22uOwquwUIp///////////ARAFGgwwNTkwMDM1NDY4NjUiDNYGay>

## Beschreibung

Die Erfindung betrifft eine Prüfkammer zur Konditionierung von Luft, umfassend einen gegenüber einer Umgebung verschließbaren und temperaturisolierten Prüfraum zur Aufnahme von Prüfgut, und zumindest ein Beleuchtungsmodul sowie ein Verfahren zum Umbau einer Prüfkammer, wobei innerhalb des Prüfraums eine Temperatur in einem Temperaturbereich von -20 °C bis +100 °C, bevorzugt von -60 °C bis +180 °C, besonders bevorzugt von -80 °C bis +300 °C, ausbildbar ist, wobei das Beleuchtungsmodul in dem Prüfraum zumindest teilweise angeordnet ist und mit dem Beleuchtungsmodul der Prüfraum beleuchtbar ist, wobei das Beleuchtungsmodul ein Leuchtmittel und eine Fassung umfasst.

Bei der Temperatur- bzw. Klimaprüfung von Prüfgut werden regelmäßig Prüfkammern mit verschließbaren Prüfräumen eingesetzt, in denen zumindest eine Temperatur und auch andere Umgebungsparameter einstellbar sind, um bestimmte klimatische oder andere Umgebungsbedingungen simulieren zu können. Das Prüfgut wird dabei innerhalb eines Prüfablaufs bzw. eines Prüfzeitabschnitts der simulierten Umgebungsbedingung ausgesetzt. Um während eines Prüfablaufs mit beispielsweise sukzessiven Temperaturwechseln eine eventuelle Veränderung des Prüfguts auch optisch feststellen zu können ist eine Beleuchtung des Prüfguts innerhalb des Prüfraums erforderlich. Diese Beleuchtung ist regelmäßig aus einem oder mehreren Beleuchtungsmodulen bzw. Leuchten gebildet, die innerhalb des Prüfraums angeordnet sind und so eine Überwachung des Prüfguts bzw. eine Inspektion des Prüfraums durch eine Person ermöglichen. Der Prüfraum selbst kann ein oder mehrere Fenster aufweisen, durch die ein Einblick in den Prüfraum möglich ist. Weiter kann die Beleuchtung des Prüfraums nicht nur während eines Prüfablaufs genutzt werden, sondern auch beim Aufbau einer Prüfkonfiguration innerhalb des Prüfraums, bei einer Reinigung des Prüfraums oder anderen Tätigkeiten in dem Prüfraum. Eine derartige Prüfkammer ist beispielsweise aus der DE 10 2016 204 378 A1 bekannt.

Eine Anordnung von Beleuchtungsmodulen bzw. Leuchten innerhalb des Prüfraums erfolgt regelmäßig an einer Innenseite einer Wand des Prüfraums so, dass eine ausreichende Ausleuchtung des Prüfraums gewährleistet ist. Diese Beleuchtungsmodule sind im Wesentlichen aus einer Fassung mit einem Leuchtmittel in einem Leuchtengehäuse ausgebildet. Das Leuchtengehäuse ist mit einem transparenten Schirm ausgebildet und kann gegenüber einer Umgebung dicht abgeschlossen sein. Dies kann insofern erforderlich sein, da je nach Prüfbedingung in dem Prüfraum Temperaturen unterhalb des Gefrierpunkts und oberhalb 100°C, hohe Luftfeuchtigkeit bzw. Nebel und/oder korrosive Flüssigkeiten, wie beispielsweise Salzlauge im Rahmen einer Prüfbedingung ausgebildet bzw. vorhanden sein können. Als Leuchtmittel wurden bisher Halogenglühlampen verwendet, da diese kostengünstig und einfach verfügbar sind. Nachteilig ist jedoch, dass Glühlampen auch den Temperaturschwankungen im Prüfraum ausgesetzt sind und nur eine kurze Lebensdauer aufweisen, wobei ein Auswechseln der Glühlampen aufwendig ist. Länger haltbare Glühlampen, sogenannte Backofenlampen, haben jedoch nur eine sehr geringe Lichtausbeute. Darüber hinaus stellen Glühlampen innerhalb des Prüfraums eine thermische Last dar, die bei einer Kühlung des Prüfraums durch eine höhere Leistung einer Temperiervorrichtung bzw. eines Kühlkreislaufs kompensiert werden muss. Eine Verwendung von Leuchtdioden als alternatives Leuchtmittel ist jedoch problematisch, da hier ein verlässlicher Einsatz nur bis zu einer Temperatur von bis zu 80 °C möglich ist. Höhere Temperaturen führen regelmäßig zu einer wesentlichen Verkürzung der Lebensdauer der Leuchtdiode.

Aufgabe der Erfindung ist es daher eine Prüfkammer mit einem Beleuchtungsmodul vorzuschlagen, die eine verlässliche Beleuchtung eines Prüfraums ermöglicht und flexibel für unterschiedliche Prüfkammern einsetzbar ist.

Diese Aufgabe wird durch eine Prüfkammer mit den Merkmalen des Anspruchs 1 gelöst und ein Verfahren zum Umbau einer Prüfkammer mit den Merkmalen des Anspruchs 11.

Die erfindungsgemäße Prüfkammer zur Konditionierung von Luft, umfasst einen gegenüber einer Umgebung verschließbaren und temperaturisolierten Prüfraum zur Aufnahme von Prüfgut, und zumindest ein Beleuchtungsmodul umfassend ein Leuchtmittel und eine Fassung, wobei innerhalb des Prüfraums eine Temperatur in einem Temperaturbereich von -20 °C bis +100 °C, bevorzugt von -60 °C bis +180 °C, besonders bevorzugt von -80 °C bis +300 °C, ausbildbar ist, wobei das Beleuchtungsmodul in dem Prüfraum zumindest teilweise angeordnet ist und mit dem Beleuchtungsmodul der Prüfraum beleuchtbar ist, wobei das Beleuchtungsmodul eine aus einem Rohr und einem weiteren Rohr oder Flansch ausgebildeten Wanddurchführung und eine Lichtleiteinrichtung umfasst, wobei das weitere Rohr oder der Flansch mit dem Rohr verbunden ist und in Art einer Teleskopführung an dem Rohr verschiebbar ausgebildet ist, wobei die Wanddurchführung in einer im Prüfraum begrenzenden Wand, von einer Innenseite zu einer Außenseite der Wand verlaufend, angeordnet ist, wobei die Lichtleiteinrichtung eine Lichtaustrittsfläche und eine Lichteintrittsfläche aufweist, und von einem innenseitigen Ende bis zu einem außenseitigen Ende der Wanddurchführung verlaufend innerhalb der Wanddurchführung angeordnet ist, wobei die Fassung an dem außenseitigen Ende angeordnet ist und das Leuchtmittel an der Lichteintrittsfläche positioniert, wobei die Lichtaustrittsfläche an dem innenseitigen Ende angeordnet ist, wobei zwischen der Wanddurchführung und der Lichtleiteinrichtung ein Spalt ausgebildet ist, wobei das Beleuchtungsmodul eine in Art eines Stopfens ausgebildete Dichtvorrichtung umfasst, wobei der Stopfen an dem innenseitigen Ende in die Wanddurchführung eingesetzt ist, wobei die Lichtleiteinrichtung durch eine Bohrung in den Stopfen eingesetzt ist, derart, dass die Lichtleiteinrichtung durch die Dichtvorrichtung hindurchtritt und die Dichtvorrichtung die Lichtleiteinrichtung an der Wanddurchführung abdichtet.

Demnach ist das erfindungsgemäße Beleuchtungsmodul so ausgebildet, dass es nicht wie aus dem Stand der Technik bekannt an einer Innenseite einer Wand des Prüfraums angeordnet ist, sondern durch die Wand hindurchtritt. Dies wird durch die Wanddurchführung ermöglicht, die die Innenseite mit der Außenseite der temperaturisolierten Wand verbindet. Innerhalb der Wanddurchführung ist die Lichtleiteinrichtung angeordnet an deren Lichteintrittsfläche das Leuchtmittel positioniert ist. Die Halterung bzw. Anordnung des Leuchtmittels an der Lichteintrittsfläche erfolgt mittels der Fassung die ihrerseits an dem außenseitigen Ende der Wanddurchführung befestigt ist. Licht bzw. ein Lichtstrom des Leuchtmittels kann über die Lichteintrittsfläche in die Lichtleiteinrichtung eingekoppelt werden und tritt dann an der Lichtaustrittsfläche aus der Lichtleiteinrichtung aus. Da die Lichtaustrittsfläche an dem innenseitigen Ende der Wanddurchführung angeordnet ist, kann mit dem austretenden Licht der Prüfraum beleuchtet werden.

Wesentlich ist, dass sich das Leuchtmittel im Bereich des außenseitigen Endes der Wanddurchführung befindet. Da das Leuchtmittel über die Lichtleiteinrichtung von dem Prüfraum beabstandet ist, bzw. sich außerhalb des Prüfraums befindet, ist das Leuchtmittel nicht mehr hohen Temperaturen oder Temperaturschwankungen ausgesetzt. Es kann daher prinzipiell jede erdenkliche Art eines Leuchtmittels zur Ausbildung des Beleuchtungsmoduls verwendet werden. Darüber hinaus kommt es auch nicht mehr zum Eintrag einer Wärmelast über das Leuchtmittel in den Prüfraum, was einen energetisch vorteilhaften Betrieb einer Kühleinrichtung der Prüfkammer ermöglicht. Gleichzeitig ist es dann auch möglich einen vergleichsweise hohen Lichtstrom in die Lichtleiteinrichtung einzukoppeln um eine noch bessere Ausleuchtung des Prüfraums zu erzielen. Da das Leuchtmittel keinen extremen Temperaturen mehr ausgesetzt ist, wird eine Lebensdauer des Leuchtmittels wesentlich verlängert. Gleichzeitig wird ein einfacher Austausch des Leuchtmittels während eines Betriebs der Prüfkammer möglich. Ein Volumen des Prüfraums kann ebenfalls dadurch vergrößert werden, dass kein Leuchtengehäuse mehr innerhalb des Prüfraums angeordnet werden muss. Erfindungsgemäß ist zwischen der Wanddurchführung und der Lichtleiteinrichtung ein Spalt ausgebildet. Die Lichtleiteinrichtung ist dann von der Wanddurchführung thermisch entkoppelt. Beispielsweise kann die Lichtleiteinrichtung mit Abstandshaltern in der Wanddurchführung so angeordnet sein, dass sich der Spalt ergibt. Ein Abstandshalter kann beispielsweise in Art einer kreisringförmigen Scheibe ausgebildet sein. Erfindungsgemäß umfasst das Beleuchtungsmodul eine Dichtvorrichtung, wobei die Dichtvorrichtung an dem innenseitigen Ende angeordnet ist, wobei die Lichtleiteinrichtung durch die Dichtvorrichtung hindurchtritt und die Dichtvorrichtung die Lichtleiteinrichtung an der Wanddurchführung abdichtet. Die Dichtvorrichtung ist in Art eines Stopfens ausgebildet, der an dem innenseitigen Ende in die Wanddurchführung eingesetzt ist. Die Lichtleiteinrichtung kann durch eine einfache Bohrung in den Stopfen eingesetzt sein. Die Lichtleitvorrichtung kann mit dem innenseitigen Ende der Wanddurchführung im Wesentlichen bündig abschließen oder auch das innenseitige Ende ein Stück weit überragen. Die Dichtvorrichtung kann beispielsweise aus Silikon oder einem anderen temperaturbeständigen Material bestehen.

Durch die Ausbildung der Dichtvorrichtung als Stopfen wird es möglich unter gleichzeitiger Ausbildung einer ausreichenden Dichtwirkung unterschiedliche Temperaturausdehnungskoeffizienten von Wanddurchführung, Dichtvorrichtung und Lichtleiteinrichtung über eine elastische Ausbildung des Stopfens zu kompensieren.

Erfindungsgemäß ist die Wanddurchführung aus einem Rohr ausgebildet. Das Rohr kann einen runden, rechteckigen oder quadratischen Querschnitt aufweisen. Das Rohr kann dann einfach in eine Öffnung in der Wand, die mit Außenmaßen des Rohrs korrespondiert, eingesetzt werden. Weiter kann vorgesehen sein, dass das Rohr an einem Ende, vorzugsweise an dem innenseitigen Ende einen Flansch aufweist, mit dem das Rohr dichtend an einer Seite bzw. Innenseite der Wand anliegt. Erfindungsgemäß umfasst die Wanddurchführung ein weiteres Rohr oder einen Flansch, welches bzw. welcher mit dem Rohr verbunden ist und in Art einer Teleskopführung an dem Rohr verschiebbar ausgebildet ist. Weiter können die beiden Rohre bzw. der Flansch und das Rohr formschlüssig mittels einer Gewindeverbindung miteinander verschraubt und/oder mittels einer Klebeverbindung miteinander verbunden sein. So wird es möglich die Wanddurchführung an eine Dicke der Wand einfach anzupassen. Darüber hinaus kann an dem weiteren Rohr ebenfalls ein Flansch zur verdichtenden Anlage an der Außenseite der Wand ausgebildet sein.

Die Lichtleiteinrichtung kann zumindest abschnittsweise stabförmig ausgebildet sein, wobei die Lichtleiteinrichtung aus Glas, vorzugsweise Borosilikatglas bestehen kann. Die Leichtleiteinrichtung kann aus einem monolithischen Körper aus Glas bestehen, wobei die Lichtleiteinrichtung auch Spiegel und Prismen sowie andere geeignete optische Elemente umfassen kann. Borosilikatglas ist in einem Temperaturbereich von -270 °C bis +500 °C verwendbar und gegenüber Feuchtigkeit unempfindlich. Auch ist Borosilikatglas gegenüber stark korrosiven Medien, wie Säuren oder Laugen, sehr beständig.

Die Wanddurchführung und die Lichtleiteinrichtungen können relativ zueinander koaxial angeordnet sein. Das Beleuchtungsmodul kann relativ bezogen auf seine Längsachse im Wesentlichen rotationssymmetrisch ausgebildet sein. Eine Herstellung und Montage des Beleuchtungsmoduls wird so wesentlich vereinfacht.

Das Leuchtmittel kann eine Leuchtdiode oder eine Halogenlampe sein. Eine Leuchtdiode weist eine vergleichsweise geringe Leistungsaufnahme und hohe Lebensdauer auf. Darüber hinaus können mit einer Leuchtdiode eine Lichtfarbe, ein Lichtstrom und eine Farbwiedergabe nach Bedarf angepasst werden. Eine Spannungsversorgung der Leuchtdiode kann integral mit der Leuchtdiode verbunden sein, so dass kein externes Netzwerk zum Betrieb des Beleuchtungsmoduls erforderlich ist. Die Leuchtdiode kann einen normierten Sockel aufweisen, der in eine normierte Fassung eingesetzt ist. Demnach kann die Leuchtdiode bzw. das so ausgebildete Leuchtmittel hinsichtlich seiner Gestalt einem konventionellen Leuchtmittel ähneln. Gleichwohl kann die Leuchtdiode auch an einer Platine angeordnet sein, die dann die Fassung ausbildet.

Die Fassung kann eine Kühleinrichtung und elektrische Anschlussmittel aufweisen. Die Kühleinrichtung kann beispielsweise ein Kühlkörper mit daran ausgebildeten Rippen zur Abführung von Wärme an eine Umgebung sein. Die elektrischen Anschlussmittel können elektrische Versorgungsleitungen, die an der Fassung angeschlossen sind, sein.

Das Beleuchtungsmodul kann an einer Innenseite einer den Prüfraum begrenzenden Wand bündig angeordnet werden, so dass sich keine störenden Kanten an der Innenseite des Prüfraums ergeben. So wird dann auch der Prüfraum nicht unnötig durch ein Leuchtengehäuse verkleinert. Da sich dann auch innerhalb des Prüfraumes keine Zündquellen befinden, kann die Prüfkammer ATEX-konform entsprechend der Richtlinie 214/34/EU der Europäischen Union in der am Prioritätstag gültigen Fassung ausgebildet werden.

Die Prüfkammer kann im Prüfraum begrenzende und temperaturisolierte Wände aufweisen, wobei zwischen einer Innenseite und einer Außenseite der jeweiligen Wand ein thermisches Isolationsmaterial angeordnet sein kann. Beispielsweise kann die Innenseite der Wand durch ein Edelstahlblech ausgebildet sein, wobei zwischen der Außenseite der Wand, die ebenfalls durch ein Edelstahlblech ausgebildet sein kann, das Isolationsmaterial angeordnet sein kann. Das Isolationsmaterial kann demnach im Wesentlichen die Wand vollständig ausfüllen. Eine Wanddicke kann > 5 cm, bevorzugt bis zu 10 cm, besonders bevorzugt 10 cm bis 20 cm oder mehr betragen.

Die Prüfkammer kann eine Temperiervorrichtung zur Temperierung des Prüfraums aufweisen, wobei mittels der Temperiervorrichtung eine Temperatur in einem Temperaturbereich von -20 °C bis +100 °C, bevorzugt von -60 °C bis +180 °C, besonders bevorzugt von -80 °C bis +300 °C, innerhalb des Prüfraums ausgebildet werden kann. So ist es möglich mittels der Prüfkammer Temperaturen in diesem Bereich im Prüfraum einzustellen und beispielsweise im Rahmen eines Prüfablaufs einen sukzessiven Temperaturwechsel durchzuführen.

Die Temperiervorrichtung kann eine Kühleinrichtung mit einem Kältemittel, einem Verdichter, einem Kondensator und einem Expansionsventil in einem Kreislauf mit einem innerhalb des Prüfraums angeordneten ersten Wärmetauscher aufweisen, wobei das Kältemittel dem ersten Wärmetauscher zugeführt werden kann, wobei die Temperiervorrichtung eine Heizeinrichtung mit einer Heizung und einem innerhalb des Prüfraums angeordneten zweiten Wärmetauscher aufweisen kann. So ist es möglich über den ersten Wärmetauscher eine Kühlung des Prüfraums und über den zweiten Wärmetauscher eine Beheizung des Prüfraums zu bewirken. Der zweite Wärmetauscher kann durch eine Elektroheizung ausgebildet sein.

Weiter kann der Prüfraum zur Aufnahme einer korrosiven Flüssigkeit ausgebildet sein. Eine korrosive Flüssigkeit kann beispielsweise eine Säure oder eine Lauge sein. Wesentlich ist daher, dass eine Innenseite einer Wand des Prüfraums zumindest so beschaffen ist, dass sie beständig gegenüber der korrosiven Flüssigkeit ist. Die Innenseite kann beispielsweise auch durch eine entsprechende Beschichtung korrosionsbeständig ausgebildet sein.

Die Prüfkammer kann eine Steuervorrichtung zur Einstellung einer Prüfbedingung durch eine Steuerung und/oder eine Regelung einer Lufttemperatur, eines Luftdrucks und einer relativen Luftfeuchte in dem Prüfraum aufweisen. Mit der Steuervorrichtung ist es dann möglich einen Prüfablauf zu steuern. Gleichzeitig kann über die Steuervorrichtung ein Ein- und Ausschalten des bzw. der Beleuchtungsmodule erfolgen.

Bei dem erfindungsgemäßen Verfahren zum Umbau einer Prüfkammer mit einem gegenüber einer Umgebung verschließbaren und temperaturisolierten Prüfraum zur Aufnahme von Prüfgut, wobei innerhalb des Prüfraums eine Temperatur in einem Temperaturbereich von -20 °C bis +100 °C, bevorzugt von -60 °C bis +180 °C, besonders bevorzugt von - 80 °C bis +300 °C, ausbildbar ist, wird eine innerhalb des Prüfraums an einer Innenseite einer temperaturisolierten den Prüfraum begrenzenden Wand der Prüfkammer angeordnete Leuchte mit einem Leuchtengehäuse demontiert, wobei in der Wand eine Durchgangsbohrung von einer Außenseite der Wand zur Innenseite ausgebildet wird, wobei ein Beleuchtungsmodul mit einer aus einem Rohr und einem weiteren Rohr oder Flansch ausgebildeten Wanddurchführung, einer Lichtleiteinrichtung, einem Leuchtmittel und einer Fassung in die Durchgangsbohrung eingesetzt wird, derart, dass die Wanddurchführung von der Innenseite zu der Außenseite der Wand verläuft, wobei das weitere Rohr oder der Flansch in Art einer Teleskopführung an dem Rohr verschiebbar ausgebildet ist und mit dem Rohr verbunden wird, wobei die Lichtleiteinrichtung eine Lichtaustrittsfläche und eine Lichteintrittsfläche aufweist und von einem innenseitigen Ende bis zu einem außenseitigen Ende der Wanddurchführung verlaufend innerhalb der Wanddurchführung angeordnet wird, wobei die Fassung an dem außenseitigen Ende angeordnet wird und das Leuchtmittel an der Lichteintrittsfläche positioniert, wobei die Lichtaustrittsfläche an dem innenseitigen Ende angeordnet wird, wobei zwischen der Wanddurchführung und der Lichtleiteinrichtung ein Spalt ausgebildet wird, wobei das Beleuchtungsmodul eine in Art eines Stopfens ausgebildete Dichtvorrichtung umfasst, wobei der Stopfen an dem innenseitigen Ende in die Wanddurchführung eingesetzt wird, wobei die Lichtleiteinrichtung durch eine Bohrung in den Stopfen eingesetzt wird, derart, dass die Lichtleiteinrichtung durch die Dichtvorrichtung hindurchtritt und die Dichtvorrichtung die Lichtleiteinrichtung an der Wanddurchführung abdichtet.

Zu den Vorteilten des erfindungsgemäßen Verfahrens wird auf die Vorteilsbeschreibung der erfindungsgemäßen Prüfkammer verwiesen. Weitere vorteilhafte Ausführungsformen des Verfahrens ergeben sich aus den Merkmalsbeschreibungen der auf den Vorrichtungsanspruch 1 rückbezogenen Unteransprüchen.

Die **Figur** zeigt eine Längsschnittansicht eines Beleuchtungsmoduls 10 in einer abschnittsweise dargestellten Wand 11 einer hier nicht weiter ersichtlichen Prüfkammer. Die Wand 11 begrenzt einen Prüfraum 12 und schließt diesen dicht gegenüber einer Umgebung 13 ab. Die Wand 11 ist aus Blechen 14 und 15 ausgebildet die im Wesentlichen relativ zueinander parallel angeordnet sind und die einen Zwischenraum 16 ausbilden, der mit einem Isolationsmaterial 17 zur Temperaturisolierung ausgefüllt ist. In der Wand 11 ist eine Durchgangsbohrung 18 ausgebildet, in die das Beleuchtungsmodul 10 eingesetzt ist. Das Beleuchtungsmodul 10 umfasst eine Fassung 19 mit einem als Leuchtdiode 20 ausgebildeten Leuchtmittel 21, eine Wanddurchführung 22 und eine Lichtleiteinrichtung 23. Die Wanddurchführung 22 verläuft von einer Innenseite 24 zu einer Außenseite 25 der Wand 11. Insbesondere ist an der Innenseite 24 bzw. einem innenseitigen Ende 26 eines Rohrs 27 der Wanddurchführung 22 ein Flansch 28 ausgebildet, der dicht an der Innenseite 24 anliegt. An einem außenseitigen Ende 29 der Wanddurchführung 22 ist ein ringförmiger Flansch 30 der Wanddurchführung 22 an der Außenseite 25 befestigt. Die Wanddurchführung 22 ist an eine Dicke der Wand 11 dadurch anpassbar, dass das Rohr 27 innerhalb des Flansches 30 teleskopartig bewegbar ist. Eine Verbindung von dem Rohr 27 mit dem Flansch 30 kann durch ein hier nicht dargestelltes Gewinde, durch Strecken und/oder eine Klebeverbindung erfolgen.

Innerhalb der Wanddurchführung 22 ist die Lichtleiteinrichtung 23 angeordnet, die hier durch einen Glasstab 31 ausgebildet ist. Der Glasstab 31 ist relativ zu dem Rohr 27 bzw. dem Flansch 30 koaxial in Richtung einer Längsachse 32 des Beleuchtungsmoduls 10 angeordnet und bildet eine Lichtaustrittsfläche 33 und eine Lichteintrittsfläche 34 aus. Weiter weist das Beleuchtungsmodul 10 eine Dichtvorrichtung 35 auf, die als ein Stopfen 36 ausgebildet ist. Der Glasstab 31 tritt durch den Stopfen 36 hindurch, so dass die Lichtaustrittsfläche 33 an dem innenseitigen Ende 26 in dem Prüfraum 12 liegt. Weiter ist der Glasstab 31 durch kreisringförmige Scheiben 37 und 38 in der Wanddurchführung 22 gehaltert. Zwischen der Wanddurchführung 22 und dem Glasstab 31 wird so ein Spalt 39 ausgebildet. Die Fassung 19 ist an dem außenseitigen Ende 29 angeordnet und nimmt die Leuchtdiode 20 auf. An der Fassung 19 sind Kühlrippen 40 einer Kühleinrichtung 41 der Fassung 19 ausgebildet sowie Kabel 42 zur Leuchtdiode 20 geführt. Von der Leuchtdiode 20 emittiertes Licht tritt in die Lichteintrittsfläche 34 des Glasstabs 31 ein und aus der Lichtaustrittsfläche 33 in den Prüfraum 12 aus, so dass eine Beleuchtung des Prüfraums 12 erfolgt. Durch die Leuchtdiode 20 abgegebene Wärme kann über die Kühleinrichtung 41 an die Umgebung 13 abgegeben werden. Dadurch, dass die Leuchtdiode 20 über den Glasstab 31 vom Prüfraum 12 weit beabstandet ist, und auch aufgrund des Spalts 39 und des Isolationsmaterials 17 keine wesentliche Beeinflussung der Leuchtdiode 20 durch im Prüfraum 12 vorherrschende Temperaturen und Umgebungsbedingungen erfolgt, wird es überhaupt erst möglich die Leuchtdiode 20 mit einer vergleichsweise langen Lebensdauer zu verwenden.

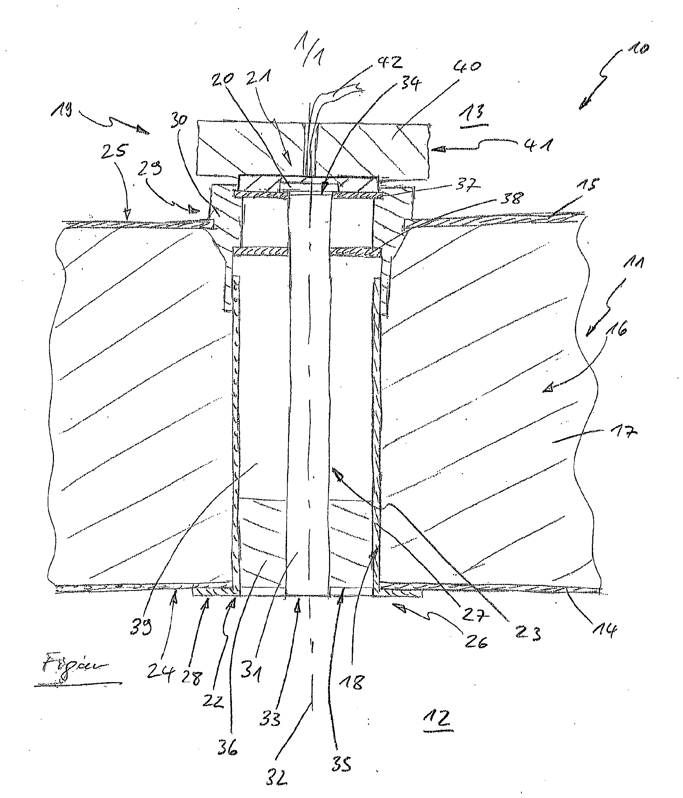

## Patentansprüche

1. Prüfkammer zur Konditionierung von Luft, umfassend einen gegenüber einer Umgebung (13) verschließbaren und temperaturisolierten Prüfraum (12) zur Aufnahme von Prüfgut, und zumindest ein Beleuchtungsmodul (10), wobei innerhalb des Prüfraums eine Temperatur in einem Temperaturbereich von -20 °C bis +100 °C, bevorzugt von -60 °C bis +180 °C, besonders bevorzugt von -80 °C bis +300 °C, ausbildbar ist, wobei das Beleuchtungsmodul in dem Prüfraum zumindest teilweise angeordnet ist und mit dem Beleuchtungsmodul der Prüfraum beleuchtbar ist, wobei das Beleuchtungsmodul ein Leuchtmittel (21) und eine Fassung (19) umfasst,
**dadurch gekennzeichnet,**
**dass** das Beleuchtungsmodul eine aus einem Rohr (27) und einem weiteren Rohr oder Flansch (30) ausgebildeten Wanddurchführung (22) und eine Lichtleiteinrichtung (23) umfasst, wobei das weitere Rohr oder der Flansch mit dem Rohr verbunden ist und in Art einer Teleskopführung an dem Rohr verschiebbar ausgebildet ist, wobei die Wanddurchführung in einer den Prüfraum begrenzenden Wand (11), von einer Innenseite (24) zu einer Außenseite (25) der Wand verlaufend, angeordnet ist, wobei die Lichtleiteinrichtung eine Lichtaustrittsfläche (33) und eine Lichteintrittsfläche (34) aufweist und von einem innenseitigen Ende (26) bis zu einem außenseitigen Ende (29) der Wanddurchführung verlaufend innerhalb der Wanddurchführung angeordnet ist, wobei die Fassung an dem außenseitigen Ende angeordnet ist und das Leuchtmittel an der Lichteintrittsfläche positioniert, wobei die Lichtaustrittsfläche an dem innenseitigen Ende angeordnet ist, wobei zwischen der Wanddurchführung und der Lichtleiteinrichtung ein Spalt (39) ausgebildet ist, wobei das Beleuchtungsmodul eine in Art eines Stopfens (36) ausgebildete Dichtvorrichtung (35) umfasst, wobei der Stopfen an dem innenseitigen Ende in die Wanddurchführung eingesetzt ist, wobei die Lichtleiteinrichtung durch eine Bohrung in den Stopfen eingesetzt ist, derart, dass die Lichtleiteinrichtung durch die Dichtvorrichtung hindurchtritt und die Dichtvorrichtung die Lichtleiteinrichtung an der Wanddurchführung abdichtet.

2. Prüfkammer nach Anspruch 1,
**dadurch gekennzeichnet,**
**dass** die Lichtleiteinrichtung (23) zumindest abschnittsweise stabförmig ausgebildet ist, wobei die Lichtleiteinrichtung aus Glas, vorzugsweise Borosilikatglas besteht.

3. Prüfkammer nach Anspruch 1 oder 2,
**dadurch gekennzeichnet,**
**dass** die Wanddurchführung (22) und die Lichtleiteinrichtung (23) relativ zueinander koaxial angeordnet sind.

4. Prüfkammer nach einem der vorangehenden Ansprüche,
**dadurch gekennzeichnet,**
**dass** das Leuchtmittel (21) eine Leuchtdiode (20) oder eine Halogenlampe ist.

5. Prüfkammer nach einem der vorangehenden Ansprüche,
**dadurch gekennzeichnet,**
**dass** die Fassung (19) eine Kühleinrichtung (41) und elektrische Anschlussmittel (42) aufweist.

6. Prüfkammer nach einem der vorangehenden Ansprüche ,
**dadurch gekennzeichnet,**
**dass** die Prüfkammer den Prüfraum (12) begrenzende und temperaturisolierte Wände (11) aufweist, wobei zwischen einer Innenseite (24) und einer Außenseite (25) der Wand ein thermisches Isolationsmaterial (17) angeordnet ist.

7. Prüfkammer nach einem der vorangehenden Ansprüche,
**dadurch gekennzeichnet,**
**dass** die Prüfkammer eine Temperiervorrichtung zur Temperierung des Prüfraums (12) aufweist, wobei mittels der Temperiervorrichtung eine Temperatur in einem Temperaturbereich von -20 °C bis +100 °C, bevorzugt von -60 °C bis +180 °C, besonders bevorzugt von -80 °C bis +300 °C, innerhalb des Prüfraums ausbildbar ist.

8. Prüfkammer nach Anspruch 7,
**dadurch gekennzeichnet,**
**dass** die Temperiervorrichtung eine Kühleinrichtung mit einem Kältemittel, einem Verdichter, einem Kondensator und einem Expansionsventil in einem Kreislauf mit einem innerhalb des Prüfraums (12) angeordneten ersten Wärmetauscher aufweist, wobei das Kältemittel dem ersten Wärmetauscher zuführbar ist, wobei die Temperiervorrichtung eine Heizeinrichtung mit einer Heizung und einem innerhalb des Prüfraums angeordneten zweiten Wärmetauscher aufweist.

9. Prüfkammer nach einem der vorangehenden Ansprüche,
**dadurch gekennzeichnet,**
**dass** eine Innenseite der Wand des Prüfraums (12) beständig gegenüber einer korrosiven Flüssigkeit ausgebildet ist.

10. Prüfkammer nach einem der vorangehenden Ansprüche,
**dadurch gekennzeichnet,**
**dass** die Prüfkammer eine Steuervorrichtung zur Einstellung einer Prüfbedingung durch eine Steuerung und/oder Regelung einer Lufttemperatur, eines Luftdrucks und einer relativen Luftfeuchte in dem Prüfraum (12) aufweist.

11. Verfahren zum Umbau einer Prüfkammer mit einem gegenüber einer Umgebung (13) verschließbaren und temperaturisolierten Prüfraum (12) zur Aufnahme von Prüfgut, wobei innerhalb des Prüfraums eine Temperatur in einem Temperaturbereich von -20 °C bis +100 °C, bevorzugt von -60 °C bis +180 °C, besonders bevorzugt von -80 °C bis +300 °C, ausbildbar ist, wobei eine innerhalb des Prüfraums an einer Innenseite (24) einer temperaturisolierten den Prüfraum begrenzenden Wand (11) der Prüfkammer angeordnete Leuchte mit einem Leuchtengehäuse demontiert wird, wobei in der Wand eine Durchgangsbohrung (18) zwischen einer Außenseite (25) der Wand und der Innenseite ausgebildet wird, wobei ein Beleuchtungsmodul (10) mit einer aus einem Rohr (27) und einem weiteren Rohr oder Flansch (30) ausgebildeten Wanddurchführung (22), einer Lichtleiteinrichtung (23), einem Leuchtmittel (21) und einer Fassung (19) in die Durchgangsbohrung eingesetzt wird, derart, dass die Wanddurchführung von der Innenseite zu der Außenseite der Wand verläuft, wobei das weitere Rohr oder der Flansch in Art einer Teleskopführung an dem Rohr verschiebbar ausgebildet ist und mit dem Rohr verbunden wird, wobei die Lichtleiteinrichtung eine Lichtaustrittsfläche (33) und eine Lichteintrittsfläche (34) aufweist und von einem innenseitigen Ende (26) bis zu einem außenseitigen Ende (29) der Wanddurchführung verlaufend innerhalb der Wanddurchführung angeordnet wird, wobei die Fassung an dem außenseitigen Ende angeordnet wird und das Leuchtmittel an der Lichteintrittsfläche positioniert, wobei die Lichtaustrittsfläche an dem innenseitigen Ende angeordnet wird, wobei zwischen der Wanddurchführung und der Lichtleiteinrichtung ein Spalt (39) ausgebildet wird, wobei das Beleuchtungsmodul eine in Art eines Stopfens (36) ausgebildete Dichtvorrichtung (35) umfasst, wobei der Stopfen an dem innenseitigen Ende in die Wanddurchführung eingesetzt wird, wobei die Lichtleiteinrichtung durch eine Bohrung in den Stopfen eingesetzt wird, derart, dass die Lichtleiteinrichtung durch die Dichtvorrichtung hindurchtritt und die Dichtvorrichtung die Lichtleiteinrichtung an der Wanddurchführung abdichtet.

## Claims

1. A test chamber for conditioning air, the test chamber comprising a temperature-insulated test space (12) sealable against an environment (13) for receiving test material, a temperature ranging from -20 °C to +100 °C, preferably from -60 °C to +180 °C, particularly preferably from -80 °C to +300 °C, being able to be produced within the test space, the illumination module being disposed at least partially in the test space and the test space being able to be illuminated by the illumination module, which comprises an illuminant (21) and a socket (19),
**characterized in that**
the illumination module comprises a wall duct (22) made of a tube (27) and another tube or flange (30) and a light conducting device (23), the other tube or the flange being connected to the tube and being designed in the manner of a telescope guide on the tube so as to be moveable, the wall duct being disposed in a wall (11) surrounding the test space whereby the wall duct extends from an inner side (24) to an outer side (25) of the wall, the light conducting device having a light exit area (33) and a light entry area (34) and being disposed within the wall duct whereby it extends from an inner end (26) to an outer end (29) of the wall duct, the socket being disposed at the outer end and positioning the illuminant at the light entry area, the light exit area being disposed at the inner end, a gap (39) being formed between the wall duct and the light conducting device, the illumination module (10) comprising a sealing device (35) designed in the manner of a plug (36) which is inserted in the wall duct at the inner end (26), the light conducting device being inserted in such a manner in the plug via a bore that the light conducting device passes through the sealing device and the sealing device seals the light conducting device at the wall duct.

2. The test chamber according to claim 1,
**characterized in that**
the light conducting device (23) is rod-shaped at least in sections, the light conducting device consisting of glass, preferably borosilicate glass.

3. The test chamber according to claim 1 or 2,
**characterized in that**
the wall duct (22) and the light conducting device (23) are coaxial with respect to one another.

4. The test chamber according to any of the preceding claims, **characterized in that**
the illuminant (21) is a light-emitting diode (20) or a halogen lamp.

5. The test chamber according to any one of the preceding claims, **characterized in that**
the socket (19) has a cooling device (41) and electric connecting means (42).

6. The test chamber according to any one of the preceding claims, **characterized in that**
the test chamber comprises temperature-insulated walls (11) limiting the test space (12), a thermal insulation material (17) being disposed between an inner side (24) and an outer side (25) of the wall.

7. The test chamber according to any one of the preceding claims, **characterized in that**
the test chamber comprises a temperature control device for controlling the temperature of the test space (12), a temperature ranging from -20 °C to +100 °C, preferably from -60 °C to +180 °C, particularly preferably from -80 °C to +300 °C, being able to be produced within the test space by means of the temperature control device.

8. The test chamber according to claim 7,
**characterized in that**
the temperature control device comprises a cooling device having a refrigerant, a compressor, a condenser and an expansion valve in a circuit having a first heat exchanger disposed within the test space (12), the refrigerant being able to be supplied to the first heat exchanger, the temperature control device comprising a heating device having a heater and a second heat exchanger disposed within the test space.

9. The test chamber according to any of the preceding claims, **characterized in that**
an inner side of the wall of the test space (12) is designed to resistant to a corrosive fluid.

10. The test chamber according to any of the preceding claims, **characterized in that**
the test chamber comprises a control device for setting a test condition by controlling and/or regulating an air temperature, an air pressure and a relative air humidity in the test space (12).

11. A method for modifying a test chamber having a temperature-insulated test space (12) sealable against an environment (13) for receiving test material, a temperature ranging from -20 °C to +100 °C, preferably from -60 °C to +180 °C, particularly preferably from -80 °C to +300 °C, being able to be produced within the test space, a lamp which has a lamp casing and is disposed within the test space on an inner side (24) of a temperature-insulated wall (11) of the test chamber, which surrounds the test space, being removed, a through bore (18) being formed between an outer side (25) of the wall and the inner side, an illumination module (10) comprising a wall duct (22), which is formed by a tube (27) and another tube or flange (30), a light conducting device (23), an illuminant (21) and a socket (19) being inserted into the through bore in such a manner that the wall duct extends from the inner side to the outer side of the wall, the other tube or the flange are designed so as to be moveable in the manner of a telescope guide on the tube and is connected to the tube, the light conducting device having a light exit area (33) and a light entry area (34) and being disposed within the wall duct whereby it extends from an inner end (26) to an outer end (29) of the wall duct, the socket being disposed at the outer end and positioning the illuminant at the light entry area, the light exit area being disposed at the inner end, a gap (39) being formed between the wall duct and the light conducting device, the illumination module comprising a sealing device (35) designed in the manner of a plug (36) which is inserted in the wall duct at the inner end, the light conducting device being inserted in such a manner in the plug via a bore that the light conducting device passes through the sealing device and the sealing device seals the light conducting device at the wall duct.

## Revendications

1. Chambre d'essai pour le conditionnement de l'air, la chambre d'essai comprenant un espace d'essai (12) isolé de la température et pouvant être scellé contre un environnement (13) destiné à recevoir du matériel d'essai, une température allant de -20 °C à +100 °C, de préférence de -60 °C à +180 °C, de préférence encore de -80 °C à +300 °C, pouvant être produite dans l'espace d'essai, le module d'illumination pouvant être disposé au moins partiellement dans l'espace d'essai et l'espace d'essai pouvant être illuminé par le module d'illumination, le module d'illumination comprenant un agent lumineux (21) et une douille (19),
**caractérisé en ce que**
le module d'illumination comprend un passage de paroi (22) constitué d'un tuyau (27) et d'un autre tuyau ou d'un flasque (30) et un dispositif de conduit de lumière (23), l'autre tuyau ou le flasque étant relié au tuyau et étant conçu à la manière d'un guide de télescope sur le tuyau de manière à pouvoir être déplaçable, le passage de paroi étant disposé dans une paroi (11) entourant l'espace d'essai, le passage de paroi s'étendant d'un côté intérieur (24) à un côté extérieur (25) de la paroi, le dispositif de conduit de lumière ayant une zone de sortie de lumière (33) et une zone d'entrée de lumière (34) et étant disposé dans le passage de paroi où il s'étend d'une extrémité intérieure (26) à une extrémité extérieure (29) du passage de paroi, la douille étant disposée à l'extrémité extérieure et positionnant l'agent lumineux à la zone d'entrée de lumière, la zone de sortie de lumière étant disposée à l'extrémité intérieure, une fente (39) étant formée entre le passage de paroi et le dispositif de conduit de lumière, le module d'illumination (10) comprenant un dispositif d'étanchéité (35) conçu à la manière d'un bouchon (36) qui est inséré dans le passage de paroi à l'extrémité intérieure (26), le dispositif de conduit de lumière étant inséré de telle manière dans le bouchon via un perçage que le dispositif de conduit de lumière traverse le dispositif d'étanchéité et que le dispositif d'étanchéité scelle le dispositif de conduit de lumière au niveau du passage de paroi.

2. Chambre d'essai selon la revendication 1,
**caractérisé en ce que**
le dispositif de conduit de lumière (23) est en forme de tige au moins en sections, le dispositif de conduit de lumière étant constitué de verre, de préférence de verre borosilicaté.

3. Chambre d'essai selon la revendication 1 ou la revendication 2, **caractérisé en ce que**
le passage de paroi (22) et le dispositif de conduit de lumière (23) sont coaxiaux l'un par rapport à l'autre.

4. Chambre d'essai selon l'une quelconque des revendications précédentes,
**caractérisé en ce que**
l'agent lumineux (21) est une diode électroluminescente (20) ou une lampe halogène.

5. Chambre d'essai selon l'une quelconque des revendications précédentes,
**caractérisé en ce que**
la douille (19) a un dispositif de refroidissement (41) et des moyens de connexion électriques (42).

6. Chambre d'essai selon l'une quelconque des revendications précédentes,
**caractérisé en ce que**
la chambre d'essai comprend des parois (11) isolées thermiquement limitant l'espace d'essai (12), un matériau d'isolation thermique (17) étant disposé entre un côté intérieur (24) et un côté extérieur (25) de la paroi.

7. Chambre d'essai selon l'une quelconque des revendications précédentes,
**caractérisé en ce que**
la chambre d'essai comprend un dispositif de régulation de la température de l'espace d'essai (12), une température allant de -20 °C à +100 °C, de préférence de -60 °C à +180 °C, de préférence encore de -80 °C à +300 °C, pouvant être produite à l'intérieur de l'espace d'essai au moyen du dispositif de régulation de la température.

8. Chambre d'essai selon la revendication 7,
**caractérisé en ce que**
le dispositif de régulation de la température comprend un dispositif de refroidissement ayant un réfrigérant, un compresseur, un condenseur et un soupape de détente dans un circuit ayant un premier échangeur de chaleur disposé dans l'espace d'essai (12), le réfrigérant pouvant être fourni au premier échangeur de chaleur, le dispositif de régulation de la température comprenant un dispositif de chauffage ayant un chauffage et un deuxième échangeur de chaleur disposé dans l'espace d'essai.

9. Chambre d'essai selon l'une quelconque des revendications précédentes,
**caractérisé en ce**
**qu'**un côté intérieur de la paroi de l'espace d'essai (12) est conçu pour résister à un fluide corrosif.

10. Chambre d'essai selon l'une quelconque des revendications précédentes,
**caractérisé en ce que**
la chambre d'essai comprend un dispositif de contrôle pour établir une condition d'essai en contrôlant et/ou en régulant une température de l'air, une pression de l'air et une humidité relative de l'air dans l'espace d'essai (12).

11. Procédé de modification d'une chambre d'essai ayant un espace d'essai (12) isolé de la température et pouvant être scellé contre un environnement (13) destiné à recevoir du matériel d'essai, une température allant de -20 °C à +100 °C, de préférence de -60 °C à +180 °C, de préférence encore de -80 °C à +300 °C, pouvant être produite à l'intérieur de l'espace d'essai, une lampe dont le boîtier est disposé à l'intérieur de l'espace d'essai sur un côté intérieur (24) d'une paroi (11) isolée thermiquement de la chambre d'essai, qui entoure l'espace d'essai, étant enlevée, un perçage traversant (18) étant formé entre un côté extérieur (25) de la paroi et le côté intérieur, un module d'illumination (10) comprenant un passage de paroi (22), formé par un tuyau (27) et un autre tuyau ou flasque (30), un dispositif de conduit de lumière (23), un agent lumineux (21) et une douille (19) étant inséré dans le perçage traversant de telle sorte que le passage de paroi s'étende du côté intérieur au côté extérieur de la paroi, l'autre tuyau ou la flasque étant conçu de manière à pouvoir être déplaçables à la manière d'un guide de télescope sur le tuyau et étant reliés au tuyau, le dispositif de conduit de lumière ayant une zone de sortie de lumière (33) et une zone d'entrée de lumière (34) et étant disposé à l'intérieur du passage de paroi par lequel il s'étend d'une extrémité intérieure (26) à une extrémité extérieure (29) du passage de paroi, la douille étant disposée à l'extrémité extérieure et positionnant l'agent lumineux à la zone d'entrée de lumière, la zone de sortie de lumière étant disposée à l'extrémité intérieure, une fente (39) étant formée entre le passage de paroi et le dispositif de conduit de lumière, le module d'illumination comprenant un dispositif d'étanchéité (35) conçu à la manière d'un bouchon (36) qui est inséré dans le passage de paroi à l'extrémité intérieure, le dispositif de conduit de lumière étant inséré de telle manière dans le bouchon via un perçage que le dispositif de conduit de lumière traverse le dispositif d'étanchéité et que le dispositif d'étanchéité scelle le dispositif de conduit de lumière au niveau du passage de paroi.
